(19) **Europäisches Patentamt / European Patent Office / Office européen des brevets**

(11) **EP 3 749 069 A1**

(12) **EUROPEAN PATENT APPLICATION**
published in accordance with Art. 153(4) EPC

(43) Date of publication:
**09.12.2020 Bulletin 2020/50**

(21) Application number: **19748427.2**

(22) Date of filing: **24.01.2019**

(51) Int Cl.:
*H05K 1/05* (2006.01)     *H01L 23/36* (2006.01)
*H05K 3/38* (2006.01)

(86) International application number:
**PCT/JP2019/002383**

(87) International publication number:
**WO 2019/151122 (08.08.2019 Gazette 2019/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.01.2018   JP 2018013889**

(71) Applicant: **Mitsubishi Materials Corporation**
**Tokyo 100-8117 (JP)**

(72) Inventors:
• **ISHIKAWA Fumiaki**
  **Naka-shi, Ibaraki 311-0102 (JP)**
• **YAMASAKI Kazuhiko**
  **Naka-shi, Ibaraki 311-0102 (JP)**

(74) Representative: **Hoffmann Eitle**
**Patent- und Rechtsanwälte PartmbB**
**Arabellastraße 30**
**81925 München (DE)**

(54) **METAL BASE SUBSTRATE**

(57)     A metal base substrate includes a metal substrate (10), an insulating layer (20), and a metal foil (40) which are laminated in this order, wherein the metal base substrate further includes an adhesive layer (30) between the insulating layer (20) and the metal foil (40), and the adhesive layer (30) satisfies Expressions (1) to (3), in which E represents a Young's modulus at 25°C having a unit of GPa, T represents a thickness having a unit of $\mu$m, and $\lambda$ represents a thermal conductivity in a thickness direction having a unit of W/mK,

$$(1)\ E \leq 1$$

$$(2)\ 5 \leq T/E$$

$$(3)\ T/\lambda < 20.$$

**EP 3 749 069 A1**

EP 3 749 069 A1

FIG. 1

**Description**

TECHNICAL FIELD

The present invention relates to a metal base substrate.

The present application claims priority on Japanese Patent Application No. 2018-013889 filed on January 30, 2018, the content of which is incorporated herein by reference.

BACKGROUND ART

As substrates for mounting electronic components such as semiconductor elements or light-emitting diode (LED) elements, metal base substrates are known. The metal base substrate is a laminate in which a metal substrate, an insulating layer, and a metal foil are laminated in this order. An electronic component is bonded onto the metal foil via solder. The metal base substrate desirably has a high thermal conductivity so as to be capable of rapidly releasing heat generated in the electronic component to the outside. In order to improve the thermal conductivity of the metal base substrate, it is effective to enhance the adhesion between the metal substrate and the insulating layer and the adhesion between the insulating layer and the metal foil.

Patent Document 1 discloses a metal base substrate in which a first adhesive material layer is provided between a metal substrate and a polyimide film (insulating layer), and a second adhesive material layer is provided between the polyimide film (insulating layer) and a metal foil. In Patent Document 1, the thickness of each of the first adhesive material layer and the second adhesive material layer is set to 3 $\mu$m or more and 15 $\mu$m or less.

PRIOR ART DOCUMENTS

Patent Document

Patent Document 1: Japanese Unexamined Patent Application, First Publication No. 2013-143440

DISCLOSURE OF INVENTION

Problems to be Solved by the Invention

As described in Patent Document 1, it is effective to provide an adhesive material layer between the metal substrate and the insulating layer and further provide an adhesive material layer between the insulating layer and the metal foil for improving the thermal conductivity of the metal base substrate. However, in the case where the metal base substrate and an electronic component are bonded to each other via solder, in some cases, thermal stress is generated through heat shock cycles from the on-off operation of the electronic component or the ambient temperature due to the difference in coefficient of thermal expansion between the metal substrate of the metal base substrate and the electronic component. This thermal stress is applied to the solder, and the solder is likely to be damaged. As a result, there is a case where the metal base substrate is not satisfactory in terms of the bonding reliability with an electronic component via solder.

The present invention has been made in consideration of the above-described circumstances, and an object of the present invention is to provide a metal base substrate having high bonding reliability with an electronic component via solder and having a low thermal resistance from a metal foil to a metal substrate.

Solutions for Solving the Problems

In order to solve the above-described problem, a metal base substrate of the present invention includes a metal substrate, an insulating layer, and a metal foil which are laminated in this order, the metal base substrate further includes an adhesive layer between the insulating layer and the metal foil, and the adhesive layer satisfies Expressions (1) to (3), in which E represents a Young's modulus at 25°C having a unit of GPa, T represents a thickness having a unit of $\mu$m, and $\lambda$ represents a thermal conductivity in a thickness direction having a unit of W/mK.

$$(1)\ \mathrm{E} \leq 1$$

$$(2)\ 5 \leq T/E$$

$$(3)\ T/\lambda < 20$$

According to the metal base substrate of the present invention having the above-described configuration, since the Young's modulus E of the adhesive layer satisfies (1) E ≤ 1, and the adhesive layer is relatively soft, the adhesive layer can relax (absorb) thermal stress that is generated due to heat shock cycles and is applied to solder due to the difference in coefficient of thermal expansion between the metal substrate of the metal base substrate and an electronic component. In addition, since the adhesion between the insulating layer and the metal foil is improved, it is possible to reduce the thermal resistance of the entire metal base substrate. Furthermore, since the relationship between the thickness T and the Young's modulus E of the adhesive layer satisfies (2) 5 ≤ T/E, and it is possible to enhance the stress relaxation capability of the adhesive layer, it is possible to reliably relax (absorb) the thermal stress applied to the solder due to heat shock cycles. Furthermore, since the relationship between the thickness T and the thermal conductivity of the adhesive layer satisfies (3) T/λ < 20, and the thermal resistance of the adhesive layer is low, it is possible to reliably reduce the thermal resistance of the entire metal base substrate.

In the metal base substrate of the present invention, it is preferable that the insulating layer includes: a resin including a polyimide resin, a polyamide-imide resin, or a mixture thereof; and ceramic particles, a specific surface area of the ceramic particles is 1 $m^2$/g or more, and an amount of the ceramic particles is in a range of 5% by volume or more and 60% by volume or less.

In this case, since the insulating layer includes the highly insulating resin (resin having high endurance voltage) and the ceramic particles having a high thermal conductivity, it is possible to further reduce the thermal resistance of the entire metal base substrate while maintaining the insulation properties.

Effects of Invention

According to this invention, it becomes possible to provide a metal base substrate having high bonding reliability with an electronic component via solder and having a low thermal resistance from a metal foil to a metal substrate.

BRIEF DESCRIPTION OF DRAWINGS

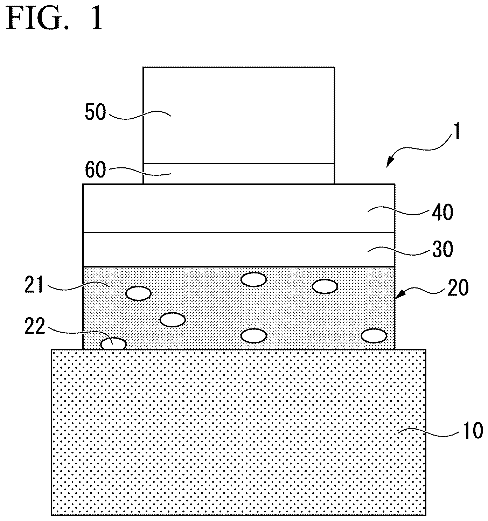

Fig. 1 is a schematic cross-sectional view of a metal base substrate according to an embodiment of the present invention.

EMBODIMENTS FOR CARRYING OUT THE INVENTION

An embodiment of the present invention will be explained below while referring to the accompanying drawing.

Fig. 1 is a schematic cross-sectional view of a metal base substrate according to an embodiment of the present invention.

In Fig. 1, a metal base substrate 1 is a laminate in which a metal substrate 10, an insulating layer 20, an adhesive layer 30, and a metal foil 40 are laminated in this order. An electronic component 50 is bonded to the surface of the metal foil 40 in the metal base substrate 1 via solder 60.

The metal substrate 10 is a member that serves as the base of the metal base substrate 1. As the metal substrate 10, it is possible to use a copper plate, an aluminum plate, or a laminate of a copper plate and an aluminum plate.

The insulating layer 20 is a layer for insulating the metal substrate 10 and the metal foil 40. The insulating layer 20 is preferably a composition including a resin 21 and ceramic particles 22. In the case where the insulating layer 20 is a composition including the highly insulating resin 21 and the ceramic particles 22 having a high thermal conductivity, it is possible to further reduce the thermal resistance of the entire metal base substrate 1 while maintaining the insulation properties.

The resin 21 included in the insulating layer 20 is preferably a polyimide resin, a polyamide-imide resin, or a mixture thereof. The polyimide resin and the polyamide-imide resin have an imide bond and thus have excellent heat resistance or mechanical properties.

The mass average molecular weights of the polyamide-imide resin and the polyimide resin are preferably 100,000 or more, and more preferably within a range of 100,000 or more and 500,000 or less. With regard to the insulating layer 20 which includes the polyamide-imide resin or the polyimide resin having a mass average molecular weight in the above-described range, the heat resistance and mechanical properties are further improved.

The ceramic particles 22 included in the insulating layer 20 preferably has a specific surface area of 1 m$^2$/g or more. In the case where the specific surface area of the ceramic particles is too small, that is, in the case where the particle diameters of the primary particles of the ceramic particles 22 are too large, there is a concern that the voltage endurance of the insulating layer 20 may degrade.

In order to prevent the degradation of the voltage endurance of the insulating layer 20, the specific surface area of the ceramic particles 22 is more preferably 10 m$^2$/g or more, and particularly preferably 50 m$^2$/g or more.

In the case where the specific surface area of the ceramic particles 22 is too large, that is, in the case where the particle diameters of the primary particles of the ceramic particles 22 are too small, the ceramic particles 22 are likely to form excessively large aggregated particles, and there is a concern that the surface roughness Ra of the insulating layer 20 may become large. In the case where the surface roughness Ra of the insulating layer 20 becomes excessively large, the surface roughness Ra of the adhesive layer 30 or the metal foil 40 laminated on the insulating layer 20 is likely to become large. In the case where the surface roughness Ra of the metal foil 40 becomes large, a gap is generated between the metal foil 40 and the solder 60, which is likely to create a problem of the peeling of the metal foil 40 and the solder 60, the degradation of the thermal conductivity between the metal foil 40 and the solder 60, or the like. Therefore, the surface roughness Ra of the insulating layer 20 is preferably small. In order to prevent the surface roughness Ra of the insulating layer 20 from becoming excessively large, the specific surface area of the ceramic particles is preferably 300 m$^2$/g or less.

The specific surface area of the ceramic particles 22 is a BET specific surface area measured by the BET method. The specific surface area of the ceramic particles 22 in the insulating layer 20 can be measured by heating the insulating layer 20, thermally decomposing and removing the resin 21 component, and recovering the remaining ceramic particles 22.

With regard to the ceramic particles 22, the BET diameter calculated from the BET specific surface area and the density using the following expression is preferably within a range of 1 nm or more and 200 nm or less. With regard to the insulating layer 20 which includes the ceramic particles 22 having a BET diameter in the above-described range, the voltage endurance is further improved.

$$\text{BET diameter} = 6/(\text{density} \times \text{BET specific surface area})$$

The ceramic particles 22 preferably form aggregated particles. The aggregated particles may be an agglomerate in which the primary particles are relatively weakly linked to each other or may be an aggregate in which the primary particles are relatively strongly linked to each other. In addition, the aggregated particles may form a particle assemblage in which the aggregated particles further assemble to each other. In the case where the primary particles of the ceramic particles 22 form the aggregated particles and are dispersed in the insulating layer 20, the mutual contact between the ceramic particles 22 form a network, it becomes easy for heat to be conducted between the primary particles of the ceramic particles 22, and the thermal conductivity of the insulating layer 20 is improved.

In addition, the ceramic particles 22 are preferably highly crystalline, and the primary particles are more preferably single crystal particles. Since the ceramic particles of a highly crystalline single crystal are excellent in terms of thermal conductivity, the thermal conductivity of the insulating layer 20 including these ceramic particles is improved more efficiently.

The aggregated particles of the ceramic particles 22 preferably have an anisotropic shape in which the primary particles are linked to each other by point contact. In this case, it is preferable that the primary particles of the ceramic particles 22 bond to each other chemically and strongly.

In addition, the average particle diameter of the aggregated particles of the ceramic particles 22 is preferably 5 times or more the above-described BET diameter, and preferably within a range of 5 times or more and 100 times or less the above-described BET diameter. In addition, the average particle diameter of the aggregated particles is preferably within a range of 20 nm or more and 500 nm or less. In the case where the average particle diameter of the aggregated particles is in the above-described range, it is possible to reliably improve the thermal conductivity of the insulating layer 20.

The average particle diameter of the aggregated particles is a value of Dv50 measured with a laser diffraction-type particle size distribution measurement instrument after dispersing the ceramic particles in an NMP solvent with ultrasonic waves together with a dispersant. The aggregated particles (ceramic particles) in the insulating layer 20 can be recovered by heating the insulating layer 20 to thermally decompose and remove the resin component.

The amount of the ceramic particles in the insulating layer 20 is preferably within a range of 5% by volume or more and 60% by volume or less. In the case where the amount of the ceramic particles is too small, there is a concern that the thermal conductivity of the insulating layer 20 may not sufficiently improve. On the other hand, in the case where the amount of the ceramic particles 22 is too large, the amount of the resin 21 relatively decreases, and there is a concern that it may become impossible to stably maintain the shape of the insulating layer 20. In addition, the ceramic particles 22 are likely to form excessively large aggregated particles, and there is a concern that the surface roughness Ra of the insulating layer 20 may increase.

In order to reliably improve the thermal conductivity of the insulating layer 20, the amount of the ceramic particles 22 is preferably 10% by volume or more, and more preferably 30% by volume or more. In addition, in order to reliably improve the shape stability of the insulating layer 20 and decrease the surface roughness Ra, the amount of the ceramic particles is particularly preferably 50% by volume or less.

Examples of the ceramic particles 22 include silica (silicon dioxide) particles, alumina (aluminum oxide) particles, boron nitride particles, titanium oxide particles, alumina-doped silica particles, hydrated alumina particles, and aluminum nitride particles. Either one of these ceramic particles 22 may be used or a combination of two or more of these ceramic particles may be used. Among these ceramic particles, alumina particles are preferred because of the high thermal conductivity.

As the ceramic particles 22, a commercially available product may be used. As the commercially available product, it is possible to use silica particles such as AE50, AE130, AE200, AE300, AE380, and AE90E (all manufactured by Nippon Aerosil Co., Ltd.), T400 (manufactured by Wacker Chemie AG) and SFP-20M (manufactured by Denka Company Limited), alumina particles such as Alu65 (manufactured by Nippon Aerosil Co., Ltd.) and AA-04 (manufactured by Sumitomo Chemical Co., Ltd.), boron nitride particles such as AP-170S (manufactured by Maruka Corporation), titanium oxide particles such as AEROXIDE (R) TiO2 P90 (manufactured by Nippon Aerosil Co., Ltd.), alumina-doped silica particles such as MOX170 (manufactured by Nippon Aerosil Co., Ltd.), and hydrated alumina particles manufactured by Sasol Limited.

The thickness of the insulating layer 20 is not particularly limited, but is preferably within a range of 2 $\mu$m or more and 100 $\mu$m or less, and particularly preferably within a range of 3 $\mu$m or more and 50 $\mu$m or less.

The adhesive layer 30 satisfies Expressions (1) to (3), in which E represents the Young's modulus at 25°C having a unit of GPa, T represents the thickness having a unit of $\mu$m, and $\lambda$ represents the thermal conductivity in the thickness direction having a unit of W/mK.

$$(1)\ E \leq 1$$

$$(2)\ 5 \leq T/E$$

$$(3)\ T/\lambda < 20$$

The adhesive layer 30 satisfies (1) E $\leq$ 1, that is, the Young's modulus E at 25°C is set to 1 GPa or less. In the case where the Young's modulus E of the adhesive layer 30 exceeds 1 GPa, it is necessary to increase the thickness of the adhesive layer 30 in order to relax, in the adhesive layer 30, thermal stress applied to the solder 60 due to heat shock cycles. In the case where the thickness of the adhesive layer 30 is thick, the thermal resistance of the entire metal base substrate 1 increases, and there is a concern that it may become difficult to emit heat generated in the electronic component 50 to the outside. The Young's modulus E of the adhesive layer 30 is preferably within a range of 0.1 GPa or more and 0.5 GPa or less.

The adhesive layer 30 satisfies (2) 5 $\leq$ T/E, that is, the ratio T/E of the thickness T (unit: $\mu$m) to the Young's modulus E (unit: GPa) at 25°C is set to 5 or more. In the case where the ratio T/E is less than 5, there is a concern that it may become difficult to relax, in the adhesive layer 30, thermal stress applied to the solder 60 due to heat shock cycles. The ratio T/E is preferably 10 or more. The upper limit of the ratio T/E is not particularly limited, and is ordinarily 200 or less.

The adhesive layer 30 satisfies (3) T/$\lambda$ < 20, that is, the ratio T/$\lambda$ of the thickness T (unit: $\mu$m) to the thermal conductivity $\lambda$ (unit: W/mK) in the thickness direction is set to less than 20. In the case where the ratio T/$\lambda$ is 20 or more, the thermal resistance of the entire metal base substrate 1 increases, and there is a concern that it may become difficult to emit heat generated in the electronic component 50 to the outside. The thermal conductivity $\lambda$ of the adhesive layer 30 is preferably within a range of 0.1 W/mK or more and 2 W/mK or less. The ratio T/$\lambda$ is preferably 15 or less. The lower limit of the ratio T/$\lambda$ is not particularly limited, and is ordinarily one or more.

The thickness T of the adhesive layer 30 is preferably within a range of 0.5 $\mu$m or more and 20 $\mu$m or less, and more preferably within a range of 0.5 $\mu$m or more and 2 $\mu$m or less.

The adhesive layer 30 preferably includes a resin. As the resin, it is possible to use a silicone resin, an epoxy resin, a polyamide-imide resin, or a polyimide resin. Examples of the silicone resin include a modified silicone resin into which various organic groups are introduced. Examples of the modified silicone resins include polyimide-modified silicone resins, polyester-modified silicone resins, urethane-modified silicone resins, acrylic-modified silicone resins, olefin-modified silicone resins, ether-modified silicone resins, alcohol-modified silicone resins, fluorine-modified silicone resins, amino-modified silicone resins, mercapto-modified silicone resins, and carboxy-modified silicone resins. Examples of the epoxy resins include bisphenol A epoxy resins, bisphenol F epoxy resins, novolak epoxy resins, aliphatic epoxy resins, and glycidylamine epoxy resins. Either one of these resins may be used or a combination of two or more of these resins may be used.

In the adhesive layer 30, inorganic particles may be dispersed in order to improve thermal conductivity. It is possible to use ceramic particles as the inorganic particles. Examples of the ceramic particles include silica (silicon dioxide) particles, alumina (aluminum oxide) particles, boron nitride particles, titanium oxide particles, alumina-doped silica particles, hydrated alumina particles, and aluminum nitride particles. The amount of the inorganic particles in the adhesive layer 30 is preferably within a range of 5% by volume or more and 60% by volume or less, and particularly preferably within a range of 10% by volume or more and 50% by volume or less.

The metal foil 40 is formed in a circuit pattern. The electronic component 50 is bonded via the solder 60 on the metal foil 40 formed in the circuit pattern. As a material of the metal foil 40, it is possible to use copper, aluminum, or gold. The thickness of the metal foil 40 is preferably within a range of 5 $\mu$m or more and 100 $\mu$m or less, and particularly preferably within a range of 10 $\mu$m or more and 50 $\mu$m or less. In the case where the thickness of the metal foil 40 is too thin, there is a concern that the metal foil may easily break. On the other hand, in the case where the thickness of the metal foil 40 is too thick, there is a concern that it may become difficult to form the circuit pattern by etching.

As the electronic component 50 bonded to the metal foil 40 in the metal base substrate 1, it is possible to use a semiconductor element or an LED element. As the solder 60 that bonds the metal foil 40 and the electronic component 50, it is possible to use ordinary solder, which is used to bond the metal foil 40 and the electronic component, such as Sn-Ag solder including tin (Sn) and silver (Ag), Sn-Ag-Cu solder including tin (Sn), silver (Ag) and copper (Cu), Sn-Cu solder including tin (Sn) and copper (Cu), Sn-Bi solder including tin (Sn) and bismuth (Bi), or Sn-Zn-Bi solder including tin (Sn), zinc (Zn), and bismuth (Bi).

Next, a method for manufacturing the metal base substrate 1 of the present embodiment will be explained.

It is possible to manufacture the metal base substrate 1 of the present embodiment by, for example, a method of laminating the insulating layer 20 and the adhesive layer 30 on the metal substrate 10 in this order, and then bonding the metal foil 40 on the adhesive layer 30.

As the method of forming the insulating layer 20 including a composition including the resin 21 and the ceramic particles 22 on the metal substrate 10, it is possible to use a coating method or an electrodeposition method.

In the coating method, a coating liquid for forming an insulating layer that includes the resin 21 for forming an insulating layer, the ceramic particles 22, and a solvent is coated on the surface of the metal substrate 10 to form a coated layer, and then the coated layer is heated and dried to form the insulating layer 20 on the metal substrate 10. As the method of coating the coating liquid for forming an insulating layer on the surface of the metal substrate 10, it is possible to use a spin coating method, a bar coating method, a knife coating method, a roll coating method, a blade coating method, a die coating method, a gravure coating method, a dip coating method, or the like.

In the electrodeposition method, an electrodeposition solution that includes the resin for forming an insulating layer, a polar solvent, water, a poor solvent, and a base is electrodeposited on the surface of a conductor to form an electrodeposition layer, and then the electrodeposition layer is heated and dried to form the insulating layer 20 on the metal substrate 10.

As the method of forming the adhesive layer 30 on the insulating layer 20, it is possible to use a coating method. The adhesive layer 30 can be formed by coating a coating liquid for forming an adhesive layer that includes a resin for forming an adhesive layer, a solvent, and inorganic particles to be added as necessary, on the surface of the insulating layer 20 to form a coated layer, and then, heating and drying the coated layer. As the method of coating the coating liquid for forming an adhesive layer on the surface of the insulating layer 20, it is possible to use a spin coating method, a bar coating method, a knife coating method, a roll coating method, a blade coating method, a die coating method, a gravure coating method, a dip coating method, or the like.

The metal foil 40 can be bonded by overlaying the metal foil 40 on the adhesive layer 30 and then heating the metal foil 40 while applying pressure thereto. The metal foil is preferably heated in a non-oxidizing atmosphere (for example, in a nitrogen atmosphere or in a vacuum) so as to prevent the oxidization of the metal foil 40.

According to the metal base substrate 1 of the present embodiment having the above-described configuration, since the Young's modulus E of the adhesive layer 30 at 25°C having a unit of GPa satisfies (1) E $\leq$ 1, and the adhesive layer 30 is relatively soft, it is possible to relax, in the adhesive layer 30, thermal stress generated due to heat shock cycles and applied to the solder 60 due to the difference in coefficient of thermal expansion between the metal substrate 10 in the metal base substrate 1 and the electronic component. In addition, since the adhesion between the insulating layer 20 and the metal foil 40 improves, it is possible to reduce the thermal resistance of the entire metal base substrate 1. Furthermore, since the relationship between the thickness T and the Young's modulus E of the adhesive layer 30 satisfies (2) 5 $\leq$ T/E, and the stress relaxation capability of the adhesive layer 30 can be enhanced, it is possible to reliably relax the thermal stress applied to the solder 60 due to heat shock cycles. Furthermore, since the relationship between the thickness T and the thermal conductivity in the thickness direction having a unit of W/mK of the adhesive layer 30 satisfies (3) T/λ < 20, and the thermal resistance of the adhesive layer 30 is low, it is possible to reliably reduce the thermal resistance of the entire metal base substrate 1.

In addition, in the metal base substrate 1 of the present embodiment, the insulating layer 20 is formed of the composition including the resin 21 including a polyimide resin, a polyamide-imide resin, or a mixture thereof and the ceramic particles 22, the specific surface area of the ceramic particles 22 is set to 1 m²/g or more, and the amount of the ceramic particles 22 is set in a range of 5% by volume or more and 60% by volume or less; and thereby, it is possible to further reduce the thermal resistance of the entire metal base substrate 1 while maintaining the insulation properties of the insulating layer 20.

EXAMPLES

Hereinafter, the effects of the present invention will be explained with reference to Examples.

[Invention Examples 1 to 8 and Comparative Examples 1 to 5]

(Formation of Insulating Layer by Coating Method)

A 300 mL separable flask was charged with 4,4'-diaminodiphenyl ether and NMP (N-methyl-2-pyrrolidone). The amount of NMP was adjusted such that the concentration of the obtained polyamic acid was 40% by mass. The mixture was stirred at room temperature to completely dissolve the 4,4'-diaminodiphenyl ether, and then a predetermined amount of tetracarboxylic dianhydride was added little by little such that the internal temperature did not exceed 30°C. Thereafter, stirring was continued for 16 hours under a nitrogen atmosphere to prepare a polyamic acid (polyimide precursor) solution.

As ceramic particles, alumina particles having a specific surface area shown in Table 1 were prepared. The specific surface area was the BET specific surface area measured by the BET method. 1.0 g of the prepared alumina particles was added to 10 g of NMP (N-methyl-2-pyrrolidone) and subjected to an ultrasonic treatment for 30 minutes to prepare a ceramic particle dispersion liquid.

The polyamic acid solution and the ceramic particle dispersion liquid, which were prepared as described above, were mixed together such that the amount proportions of the polyimide and the ceramic particles in a solid material (insulating layer) generated by heating respectively reached the values shown in Table 1 in terms of % by volume, and then the mixture was diluted with NMP such that the concentration of the polyamic acid in the mixture reached 5% by mass. Subsequently, the obtained mixture was subjected to a dispersion treatment by repeating a high-pressure injection treatment 10 times at a pressure of 50 MPa, using Starburst manufactured by Sugino Machine Limited, to prepare a ceramic particle-dispersed polyamic acid solution (coating liquid for forming an insulating layer).

The coating liquid for forming an insulating layer was coated on a surface of a copper substrate having a thickness of 0.3 mm and a size of 30 mm × 20 mm by the bar coating method such that the thickness of an insulating layer generated by heating reached the thickness shown in Table 1 to form a coated layer for forming an insulating layer. Next, the copper substrate on which the coated layer for forming an insulating layer was formed was placed on a hot plate and the temperature was increased from room temperature to 60°C at a rate of 3°C/min, heating was carried out at 60°C for 100 minutes, then, the temperature was further increased to 120°C at a rate of 1°C/min, and heating was carried out at 120°C for 100 minutes. Thereby, the coated layer for forming an insulating layer was dried. Thereafter, the copper substrate was heated at 250°C for 1 minute, and then was heated at 400°C for 1 minute to manufacture a copper substrate with an insulating layer.

(Formation of Adhesive Layer by Spin Coating Method)

As a resin for forming an adhesive layer, a resin shown in Table 2 was prepared. The prepared resin was dissolved in NMP to prepare a coating liquid for forming an adhesive layer having a resin concentration of 30% by mass. In Invention Examples 7 and 8, the resin (polyimide) and the alumina particles (specific surface area: 5.1 m²/g) were mixed into NMP in the proportions shown in Table 2.

The coating liquid for forming an adhesive layer was coated on the insulating layer of the copper substrate with an insulating layer by the spin coating method under the conditions where the rotation speed of a spin coater and the number of times of the coating were the values shown in Table 2 to form a coated layer for forming an adhesive layer. Next, the copper substrate with an insulating layer on which the coated layer for forming an adhesive layer was formed was heated to dry the coated layer for forming an adhesive layer; and thereby, an adhesive layer having a thickness shown in Table 2 was formed on the insulating layer.

(Bonding of Metal Foil)

A copper foil (CF-T4X-SV-18: manufactured by Fukuda Metal Foil & Powder Co., Ltd.) having a thickness of 18 $\mu$m and a width of 1 cm was overlaid on the adhesive layer and then, while a pressure of 5 MPa was applied thereto using a carbon jig, heating was carried out at a temperature of 215°C for 20 minutes in a vacuum to bond the adhesive layer and the copper foil. A metal base substrate including the copper substrate, the insulating layer, the adhesive layer, and the copper foil which were laminated in this order was manufactured as described above.

[Invention Examples 9 and 10]

(Formation of Insulating Layer by Electrodeposition Method)

As ceramic particles, alumina particles having a specific surface area shown in Table 1 were prepared. 1.0 g of the prepared ceramic particles were added to a mixed solvent including, by mass, 62.5 g of NMP (N-methyl-2-pyrrolidone), 10 g of 1M2P (1-methoxy-2-propanol), and 0.22 g of AE (amino ether), and the mixture was subjected to an ultrasonic treatment for 30 minutes to prepare a ceramic particle dispersion liquid.
Next, a polyamide-imide solution and the prepared ceramic particle dispersion liquid were mixed together such that the amount proportions of the polyamide-imide and the ceramic particles in a solid material (insulating layer) respectively reached the values shown in Table 1 in terms of % by volume; and thereby, a ceramic particle-dispersed polyamide-imide solution was prepared.
While stirring the prepared ceramic particle-dispersed polyamide-imide solution at a rotation speed of 5000 rpm, 21 g of water was added dropwise to the solution to precipitate polyamide-imide particles; and thereby, an electrodeposition solution was prepared.
A copper substrate having a thickness of 0.3 mm and a size of 30 mm × 20 mm and a stainless steel electrode were immersed in the prepared electrodeposition solution, and a DC voltage of 100 V was applied using the copper substrate as a positive electrode and the stainless steel electrode as a negative electrode to form an electrodeposition film on the surface of the copper substrate such that the thickness of an insulating layer generated by heating reached a thickness shown in Table 1. Next, the copper substrate on which the electrodeposition film was formed was heated at 250°C for 3 minutes in an air atmosphere; and thereby, the electrodeposition film was dried to manufacture a copper substrate with an insulating layer.

(Manufacturing of Adhesive Layer by Spin Coating Method)

As a resin for forming an adhesive layer, an epoxy resin was prepared.
The prepared epoxy resin was coated on the insulating layer of the copper substrate with an insulating layer by the spin coating method under the conditions where the rotation speed of a spin coater and the number of times of the coating were the values shown in Table 2 to form a coated layer for forming an adhesive layer. Next, the copper substrate with an insulating layer on which the coated layer for forming an adhesive layer was formed was heated to dry the coated layer for forming an adhesive layer; and thereby, adhesive layer having a thickness shown in Table 2 was formed on the insulating layer.

(Bonding of Metal Foil)

A copper foil (CF-T4X-SV-18: manufactured by Fukuda Metal Foil & Powder Co., Ltd.) having a thickness of 18 $\mu$m and a width of 1 cm was overlaid on the adhesive layer and then, while a pressure of 5 MPa was applied thereto using a carbon jig, heating was carried out at a temperature of 215°C for 20 minutes in a vacuum to bond the adhesive layer and the copper foil. A metal base substrate including the copper substrate, the insulating layer, the adhesive layer, and the copper foil which were laminated in this order was manufactured as described above.

[Evaluation]

The following items were evaluated for the metal base substrates manufactured in Invention Examples 1 to 10 and Comparative Examples 1 to 5. The results are shown in Table 3.

(Thicknesses of Insulating Layer and Adhesive Layer)

The thicknesses of the insulating layer and the adhesive layer were measured by burying the metal base substrate in a resin, then, exposing the cross section of the metal base substrate by polishing, and observing the exposed cross section of the metal base substrate with a laser microscope.

(Thermal Conductivity of Insulating Layer)

The thermal conductivity (thermal conductivity in the thickness direction of the insulating layer) was measured by a laser flash method using LFA477 Nanoflash manufactured by NETZSCH-Geratebau GmbH. The measurement was carried out using the copper substrate with an insulating layer before the formation of the adhesive layer. The thermal conductivity was calculated using a two-layer model which did not consider interfacial thermal resistance. The thickness of the copper substrate was set to 0.3 mm as described above and the thermal diffusivity of the copper substrate was set to 117.2 mm$^2$/sec. In order to calculate the thermal conductivity of the insulating layer, the density of the alumina particles of 3.89 g/cm$^3$, the specific heat of the alumina particles of 0.78 J/gK, the density of the polyamide-imide resin of 1.41 g/cm$^3$, and the specific heat of the polyamide-imide resin of 1.09 J/gK were used.

(Measurement of Young's Modulus of Adhesive Layer)

The copper foil in the metal base substrate was peeled off by etching to expose the adhesive layer. The Young's modulus of the exposed adhesive layer was measured using a nanoindenter. The indentation depth was set to 500 nm.

(Thermal Conductivity of Adhesive Layer)

The thermal conductivity (thermal conductivity in the thickness direction of the adhesive layer) was measured by a laser flash method using LFA477 Nanoflash manufactured by NETZSCH-Geratebau GmbH. In the measurement, a copper substrate on which the insulating layer was not formed and the adhesive layer was directly formed was used. The thermal conductivity was calculated using a two-layer model which did not consider interfacial thermal resistance. The thickness of the copper substrate was set to 0.3 mm as described above and the thermal diffusivity of the copper substrate was set to 117.2 mm$^2$/sec. In order to calculate the thermal conductivity of the insulating layer, the density of the alumina particles of 3.89 g/cm$^3$, the specific heat of the alumina particles of 0.78 J/gK, the density of the resin that formed the adhesive layer of 1.12 g/cm$^3$, and the specific heat of the resin that formed the adhesive layer of 1.12 J/gK were used.

(Bonding Reliability)

Sn-Ag-Cu solder was coated on the copper foil in the metal base substrate to form a solder layer having a length of 2.5 cm, a width of 2.5 cm, and a thickness of 100 $\mu$m, and a Si chip having a size of 2.5 cm $\times$ 2.5 cm was mounted on the solder layer; and thereby, a test body was manufactured. 3000 heat shock cycles were applied to the manufactured test body. One heat shock cycle included one cool cycle at -40°C for 30 minutes and one hot cycle at 150°C for 30 minutes. The test body after the heat shock cycles were applied was buried in a resin, a sample having the cross section exposed by polishing was observed, and the length (mm) of a crack generated in the solder layer was measured. The value calculated from the length of one side of the solder layer and the measured length of the crack using the following expression was regarded as the bonding reliability.

$$\text{Bonding reliability (\%)} = \{(\text{length of one side of solder layer (25 mm)} - 2 \times \text{length}$$

$$\text{of crack})/\text{length of one side of bonding layer (25 mm)}\} \times 100$$

(Evaluation of Thermal Resistance)

A heating element (TO-3P) was placed on the copper foil of the metal base substrate via a heat dissipation sheet (BFG-30A: manufactured by Denka Company Limited). The metal base substrate on which the heating element was placed was pressurized in the lamination direction from above the heating element by turning a screw at a torque of 40 Ncm. Then, the thermal resistance from the heating element to the copper substrate was measured using T3Ster. The heating conditions of the heating element were set to 10 A for 30 seconds, the heat resistance measurement condition was set to 0.01 A, and the measurement time was set to 60 seconds. The same measurement was carried out on a pure copper substrate on which no resin films (the insulating layer and the adhesive layer) were formed, and the value obtained by subtracting the thermal resistance of the pure copper substrate from the measured value of the metal base substrate is shown in Table 3 as the thermal resistance.

Table 1

| | Forming conditions of insulating layer | | | | | | |
| | Production method of insulating layer | Compositions of coating liquid for forming insulating layer/electrodeposition solution for forming insulating layer | | | | | Thickness (μm) |
| | | Resin | | Ceramic particles | | | |
| | | Material | Amount proportion (% by volume) | Material | Specific surface area (m$^2$/g) | Amount proportion (% by volume) | |
| Invention Example 1 | Coating method | Polyimide resin | 70 | Alumina | 2.1 | 30 | 10 |
| Invention Example 2 | Coating method | Polyimide resin | 70 | Alumina | 2.1 | 30 | 9 |
| Invention Example 3 | Coating method | Polyimide resin | 70 | Alumina | 2.1 | 30 | 7 |
| Invention Example 4 | Coating method | Polyimide resin | 70 | Alumina | 0.8 | 30 | 18 |
| Invention Example 5 | Coating method | Polyimide resin | 30 | Alumina | 2.1 | 70 | 16 |
| Invention Example 6 | Coating method | Polyimide resin | 96 | Alumina | 2.1 | 4 | 9 |
| Invention Example 7 | Coating method | Polyimide resin | 70 | Alumina | 2.1 | 30 | 7 |
| Invention Example 8 | Coating method | Polyimide resin | 70 | Alumina | 2.1 | 30 | 4 |
| Invention Example 9 | Electrodeposition method | Polyamide-imide resin | 70 | Alumina | 2.1 | 30 | 12 |
| Invention Example 10 | Electrodeposition method | Polyamide-imide resin | 70 | Alumina | 2.1 | 30 | 11 |
| Comparative Example 1 | Coating method | Polyimide resin | 70 | Alumina | 2.1 | 30 | 10 |
| Comparative Example 2 | Coating method | Polyimide resin | 70 | Alumina | 2.1 | 30 | 7 |

| | Forming conditions of insulating layer | | | | | | Thickness (μm) |
|---|---|---|---|---|---|---|---|
| | Production method of insulating layer | Compositions of coating liquid for forming insulating layer/electrodeposition solution for forming insulating layer | | | | | |
| | | Resin | | Ceramic particles | | | |
| | | Material | Amount proportion (% by volume) | Material | Specific surface area (m$^2$/g) | Amount proportion (% by volume) | |
| Comparative Example 3 | Insulating layer was not formed. | | | | | | |
| Comparative Example 4 | Coating method | Polyimide resin | 70 | Alumina | 2.1 | 30 | 12 |
| Comparative Example 5 | Coating method | Polyimide resin | 70 | Alumina | 2.1 | 30 | 3 |

Table 2

| | Forming conditions of adhesive layer | | | | | | | | |
| | Composition of coating liquid for forming adhesive layer | | | | | Resin concentration (% by mass) | Rotation speed of spin coater (rpm) | Number of times of coating | Thickness (μm) |
| | Resin | | Inorganic particles | | | | | | |
| | Material | Amount proportion (% by volume) | Material | Specific surface area (m²/g) | Amount proportion (% by volume) | | | | |
| Invention Example 1 | Pol yimide-modified silicone resin | 100 | Not added | - | - | 30 | 4000 | 1 | 2 |
| Invention Example 2 | Pol yimide-modified silicone resin | 100 | Not added | - | - | 30 | 2000 | 1 | 3 |
| Invention Example 3 | Pol yimide-modified silicone resin | 100 | Not added | - | - | 30 | 1000 | 1 | 5 |
| Invention Example 4 | Polyimide resin | 100 | Not added | - | - | 30 | 6000 | 1 | 2 |
| Invention Example 5 | Polyimide resin | 100 | Not added | - | - | 30 | 6000 | 1 | 2 |
| Invention Example 6 | Polyimide resin | 100 | Not added | - | - | 30 | 6000 | 1 | 2 |
| Invention Example 7 | Polyimide resin | 90 | Alumina | 5.1 | 10 | 30 | 3000 | 1 | 5 |
| Invention Example 8 | Polyimide resin | 70 | Alumina | 5.1 | 30 | 30 | 5000 | 2 | 10 |
| Invention Example 9 | Epoxy resin | 100 | Not added | - | - | 100 | 4000 | 1 | 1 |
| Invention Example 10 | Epoxy resin | 100 | Not added | - | - | 100 | 1000 | 1 | 2.5 |
| Comparative Example 1 | Polyimide resin | 100 | Not added | - | - | 20 | 4000 | 1 | 2 |

(continued)

| | Forming conditions of adhesive layer | | | | | | | | |
| | Composition of coating liquid for forming adhesive layer | | | | | Resin concentration (% by mass) | Rotation speed of spin coater (rpm) | Number of times of coating | Thickness (μm) |
| | Resin | | Inorganic particles | | | | | | |
| | Material | Amount proportion (% by volume) | Material | Specific surface area (m²/g) | Amount proportion (% by volume) | | | | |
| Comparative Example 2 | Polyimide resin | 100 | Not added | - | - | 20 | 1000 | 1 | 5 |
| Comparative Example 3 | Polyimide resin | 100 | Not added | - | - | 20 | 1000 | 2 | 10 |
| Comparative Example 4 | Polyimide resin | 100 | Not added | - | - | 15 | 4000 | 1 | 1 |
| Comparative Example 5 | Polyimide resin | 100 | Not added | - | - | 30 | 1000 | 2 | 10 |

Table 3

| | Insulating layer | | Adhesive layer | | | | | Bonding reliability (%) | Thermal resistance (°C/W) |
|---|---|---|---|---|---|---|---|---|---|
| | Thickness (μm) | Thermal conductivity (W/mK) | Thickness T (μm) | Young's modulus E (GPa) | Thickness T/Young's modulus E | Thermal conductivity λ (W/mK) | Thickness T/Thermal conductivity λ | | |
| Invention Example 1 | 10 | 1.4 | 2 | 0.3 | 7 | 0.4 | 5 | 90 | 0.12 |
| Invention Example 2 | 9 | 1.4 | 3 | 0.3 | 10 | 0.4 | 7.5 | 95 | 0.14 |
| Invention Example 3 | 7 | 1.4 | 5 | 0.3 | 17 | 0.4 | 12.5 | 97 | 0.18 |
| Invention Example 4 | 18 | 1.7 | 2 | 0.3 | 7 | 0.2 | 10 | 90 | 0.21 |
| Invention Example 5 | 16 | 0.9 | 2 | 0.3 | 7 | 0.2 | 10 | 90 | 0.28 |
| Invention Example 6 | 9 | 0.3 | 2 | 0.3 | 7 | 0.2 | 10 | 90 | 0.40 |
| Invention Example 7 | 7 | 1.4 | 5 | 0.17 | 29 | 0.6 | 8 | 99 | 0.13 |
| Invention Example 8 | 4 | 1.4 | 10 | 0.41 | 24 | 1.3 | 8 | 97 | 0.11 |
| Invention Example 9 | 12 | 1.4 | 1 | 0.02 | 50 | 0.2 | 5 | 99 | 0.14 |
| Invention Example 10 | 11 | 1.4 | 2.5 | 0.02 | 125 | 0.2 | 12.5 | 99 | 0.20 |
| Comparative Example 1 | 10 | 1.4 | 2 | 2 | 1 | 0.2 | 10 | 51 | 0.17 |
| Comparative Example 2 | 7 | 1.4 | 5 | 2 | 3 | 0.2 | 25 | 62 | 0.30 |
| Comparative Example 3 | Insulating layer was not formed. | | 10 | 2 | 5 | 0.2 | 50 | 88 | 0.50 |

| | Insulating layer | | Adhesive layer | | | | | Bonding reliability (%) | Thermal resistance (°C/W) |
|---|---|---|---|---|---|---|---|---|---|
| | Thickness (μm) | Thermal conductivity (W/mK) | Thickness T (μm) | Young's modulus E (GPa) | Thickness T/ Young's modulus E | Thermal conductivity λ (W/mK) | Thickness T/ Thermal conductivity λ | | |
| Comparative Example 4 | 12 | 1.4 | 1 | 0.3 | 3 | 0.2 | 5 | 81 | 0.14 |
| Comparative Example 5 | 3 | 1.4 | 10 | 0.3 | 33 | 0.2 | 50 | 99 | 0.52 |

EP 3 749 069 A1

In the metal base substrates of Comparative Examples 1 to 3 in which the Young's modulus E of the adhesive layer at 25°C exceeded the range of the present invention, when the thickness of the adhesive layer increased, the bonding reliability was improved, but the thermal resistance increased. Therefore, it is found that it is difficult to realize the improvement of the bonding reliability and the reduction of the thermal resistance in a well-balanced manner.

In the metal base substrate of Comparative Example 4 in which the Young's modulus E of the adhesive layer was in the range of the present invention, but the ratio T/E of the thickness T (unit: $\mu$m) to the Young's modulus E (unit: GPa) at 25°C was lower than the range of the present invention, the bonding reliability became poor. This is considered to be because the thickness of the adhesive layer was thin, and it was not possible to sufficiently relax, in the adhesive layer, thermal stress applied to the solder due to the heat shock cycles.

In the metal base substrate of Comparative Example 5 in which the Young's modulus E of the adhesive layer was in the range of the present invention, but the ratio T/$\lambda$ of the thickness T (unit: $\mu$m) to the thermal conductivity $\lambda$ (unit: W/mK) in the thickness direction was larger than the range of the present invention, the thermal resistance increased. This is considered to be because the thickness of the adhesive layer became too thick.

On the other hand, in the metal base substrates of Invention Examples 1 to 10 in which the Young's modulus E, the ratio T/E, and the ratio T/$\lambda$ of the adhesive layer were all in the ranges of the present invention, it was confirmed that it is possible to realize the improvement of the bonding reliability and the reduction of the thermal resistance in a well-balanced manner. Particularly, in the metal base substrates of Invention Examples 1 to 3 and 7 to 10 in which the specific surface area of the alumina particles included in the insulating layer was 1 m$^2$/g or more, and the amount of the alumina particles was within a range of 5% by volume or more and 60% by volume or less, the thermal resistance was reduced.

Industrial Applicability

According to the present invention, it is possible to improve the bonding reliability between the metal base substrate and an electronic component bonded via solder.

Explanation of Reference Signs

1 Metal base substrate
10 Metal substrate
20 Insulating layer
21 Resin
22 Ceramic particles
30 Adhesive layer
40 Metal foil
50 Electronic component
60 Solder

**Claims**

1. A metal base substrate comprising a metal substrate, an insulating layer, and a metal foil which are laminated in this order,

wherein the metal base substrate further comprises an adhesive layer between the insulating layer and the metal foil, and
the adhesive layer satisfies Expressions (1) to (3), in which E represents a Young's modulus at 25°C having a unit of GPa, T represents a thickness having a unit of $\mu$m, and $\lambda$ represents a thermal conductivity in a thickness direction having a unit of W/mK,

$$(1)\ E \leq 1$$

$$(2)\ 5 \leq T/E$$

$$(3) \; T/\lambda < 20.$$

2. The metal base substrate according to claim 1,
   wherein the insulating layer includes: a resin including a polyimide resin, a polyamide-imide resin, or a mixture thereof; and ceramic particles, a specific surface area of the ceramic particles is 1 m$^2$/g or more, and an amount of the ceramic particles is in a range of 5% by volume or more and 60% by volume or less.

FIG. 1

## INTERNATIONAL SEARCH REPORT

International application No.

PCT/JP2019/002383

A. CLASSIFICATION OF SUBJECT MATTER
Int. Cl. H05K1/05(2006.01)i, H01L23/36(2006.01)i, H05K3/38(2006.01)i

According to International Patent Classification (IPC) or to both national classification and IPC

B. FIELDS SEARCHED

Minimum documentation searched (classification system followed by classification symbols)
Int. Cl. H05K1/05, H01L23/36, H05K3/38

Documentation searched other than minimum documentation to the extent that such documents are included in the fields searched
Published examined utility model applications of Japan     1922-1996
Published unexamined utility model applications of Japan   1971-2019
Registered utility model specifications of Japan           1996-2019
Published registered utility model applications of Japan   1994-2019

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2015-43417 A (DAINIPPON PRINTING CO., LTD.) 05 March 2015, paragraphs [0025]-[0193], fig. 1-4 (Family: none) | 1, 2 |
| A | WO 2010/092905 A1 (HITACHI, LTD.) 19 August 2010, entire text & US 2012/0067631 A1, entire text & JP 2010-186789 A | 1, 2 |
| A | JP 2004-335928 A (DENKI KAGAKU KOGYO KABUSHIKI KAISHA) 25 November 2004, entire text (Family: none) | 1, 2 |
| A | JP 2006-270065 A (SANYO ELECTRIC CO., LTD.) 05 October 2006, entire text & US 2006/0204733 A1, entire text | 1, 2 |

☒ Further documents are listed in the continuation of Box C.     ☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 05.04.2019 | 16.04.2019 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.

PCT/JP2019/002383

C (Continuation). DOCUMENTS CONSIDERED TO BE RELEVANT

| Category* | Citation of document, with indication, where appropriate, of the relevant passages | Relevant to claim No. |
|---|---|---|
| A | JP 11-87866 A (DENKI KAGAKU KOGYO KABUSHIKI KAISHA) 30 March 1999, entire text (Family: none) | 1, 2 |

Form PCT/ISA/210 (continuation of second sheet) (January 2015)

**EP 3 749 069 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018013889 A
- JP 2013143440 A